# EUROPEAN PATENT APPLICATION

(11) **EP 2 999 127 A1**
(43) Date of publication of application: **23.03.2016**
(21) Application number: 13884768.6
(22) Date of filing: 14.10.2013
(51) Int. Cl.: H04B 1/38

(54) **ADHESIVE PRODUCT HOLDER**

(30) Priority: 13.05.2013 KR 20130053755
(71) Applicant: LEE, Soo Yeon, Bupyeong-gu Incheon 403-789 (KR)
(72) Inventor: LEE, Soo Yeon, Incheon 403-789 (KR)
(74) Representative: Sloboshanin, Sergej
(86) International application number: PCT/KR2013/009128
(87) International publication number: WO 2014/185602

(57) **Abstract**

The invention is a sticking type stand comprising a frame (10); an elastic supporting member (20) having an elongated shape, and the longitudinal upper end of it being mounted on the frame (10), the transverse section being curved with the central part being convex outwardly so that, if an external force is exerted on the convex front surface with the concave rear surface being supported, the longitudinal lower end of it can be elastically bent outwardly; and a sticking sheet (30) provided on the rear surface of the frame (10).

## Description

### Technical Field

The invention relates to a sticking type stand, and more particularly to a sticking type stand being able to support a smart phone or other mobile communication devices in a standing state, and also being able to support various target objects as the target objects can be detachably attached on the stand.

### Background Art

Mobile communication devices, such as a smart phone and a tablet PC, are currently widely used and these mobile devices have become necessities in this information communication society. The mobile device generally is used as being gripped by a user's hand, or as being supported on the table by use of a stand.

Meanwhile a smart phone or a tablet PC are generally used as being protected within protective cases to prevent them from being damaged or scratched on the surface of the device. And some of those protective cases have standing means to support the smart phone or the tablet PC in a standing state. But these types of protective cases are such that each protective case is provided with a supporting means, so that the user should purchase each protective case specific to each device.

In our daily life, we encounter situations in which it is convenient if we use a stand to support various articles of daily life besides the mobile communication device. For example, it is necessary to use a hand mirror in a standing state, or it is necessary to use a note or a pamphlet in a standing state. But, in these cases, there is no proper means to support them in the standing state.

### Disclosure

### Technical Problem

The invention is suggested to solve the above mentioned problems, and the object of the invention is to provide a sticking type stand being able to support various target objects as well as mobile devices, and being easy to use and store as it has a compact size.

### Technical Solution

According to an aspect of the invention, there is provided a sticking type stand comprising:
a frame 10;
an elastic supporting member 20 having an elongated shape, and the longitudinal upper end of it being mounted on the frame 10, the transverse section being curved with the central part being convex outwardly so that, if an external force is exerted on the convex front surface while the concave rear surface being supported, the longitudinal lower end of it can be elastically bent outwardly; and
a sticking sheet 30 provided on the rear surface of the frame 10,
wherein if the target object 2 is attached on the sticking sheet 30, and the convex central part of the elastic supporting member 20 is pressed, then the longitudinal lower end of the elastic supporting member 20 becomes elastically bent outwardly and comes to be supported by the floor so that the target object 2 can be supported on the floor in an inclined state.

According to another aspect of the invention, there is provided a sticking type stand, wherein the elastic supporting member 20 includes a metal plate core 22 and an elastic skin 24 surrounding the metal plate core 22.

According to another aspect of the invention, there is provided a sticking type stand, wherein the frame 10 has an opening 12 with a shape corresponding to that of the elastic supporting member 20, and the elastic supporting member 20 is seated on the opening 12.

According to the invention as described above, any proper target object can be supported by attaching the object on the sticking sheet 30 provided on the frame 10, so that various objects can be supported only by one stand, which is economical and convenient.

And only by pressing the convex central part of the elastic supporting member 20, the longitudinal lower end of the elastic supporting member 20 becomes bent outwardly and comes to be supported on the floor in the inclined state, then the target object can be supported, therefore the manipulation is easy because the user only needs to press the central part of the elastic supporting member 20.

And, as the elastic supporting member 20 includes a metal plastic core 22 and the elastic skin 24, the elastic supporting member 20 would not slip on the floor, so the target object can be supported effectively and stably. Moreover, the frame 10 has an opening 12 and the elastic supporting member 20 is seated on the opening 12, which will reduce the weight of the frame 10, and the elastic supporting member 20 will not project outside of the frame 10, so the stand can be slim and compact to have good appearance.

### Description of the Drawings

FIG. 1 is an exploded perspective of one embodiment according to the invention.
FIG. 2 is an assembled view of the above embodiment.
FIG. 3 is a sectional plan of the embodiment in FIG. 2.
FIG. 4 is a perspective view of the above embodiment in used state.
FIG. 5 is a side view of FIG. 4.

### Detailed Description of the Invention

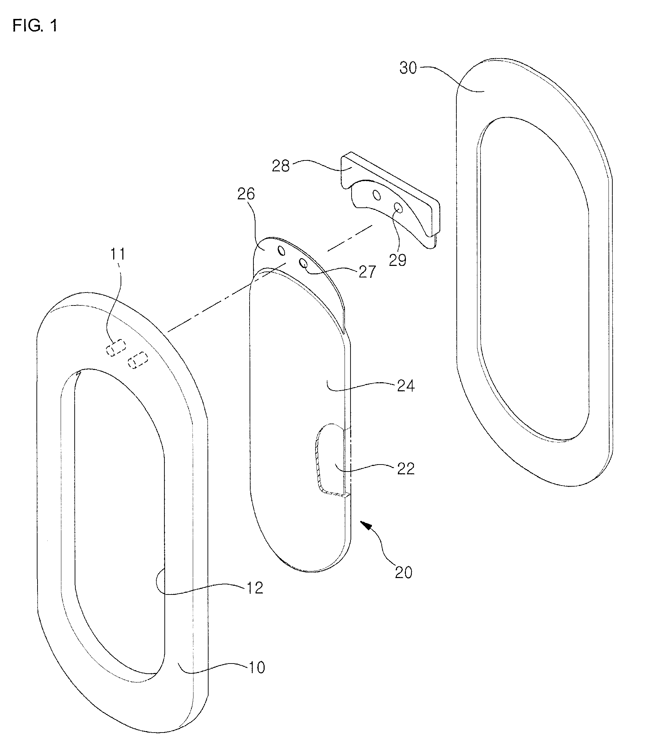

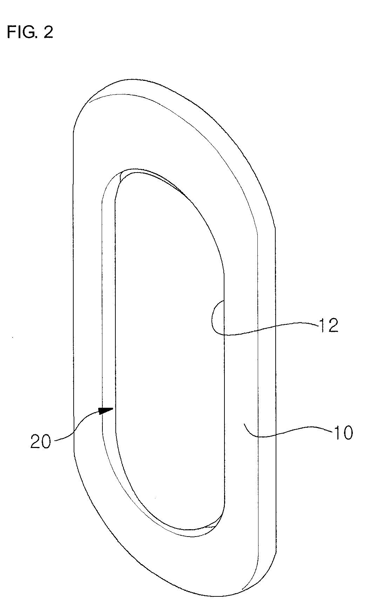

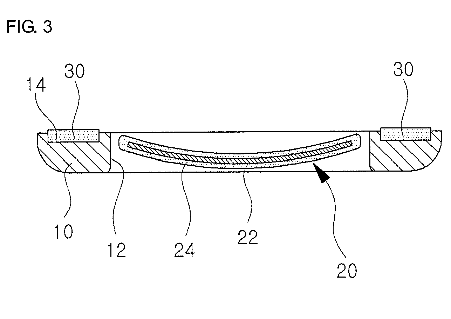

Hereinafter, the preferred embodiments of the invention will be described with reference to the drawings. FIGs. 1 to 3 show the preferred embodiment of the invention. According to the embodiment of the invention, the sticking type stand comprises a frame 10, an elastic supporting member 20, and a sticking sheet 30 positioned on the rear surface of the frame 10.

The frame 10 is in an elongated rectangular shape, and a vertically elongated opening 12 is formed on the central part of the frame 10. The frame 10 is made of plastic material. The elastic supporting member 20 is in a shape corresponding to the opening 12 and mounted on the frame 19 at the upper part. The elastic supporting member 20 includes a metal plate core 22 and a skin 24 surrounding the core 22. The core 22 is made of a metal plate with a shape corresponding to the opening 12 of the frame 10 and has an engaging portion 26 extending upwardly on the upper end of it to be engaged on the frame 10. The core 22 has a transverse section, that is, horizontal section which is convex outwardly at the central part of it. Therefore, if the convex central part of the core 22 is pressed by an external force, such as a human finger, in a state that the rear surface of the core 22 is supported, the transverse convex of the core 22 becomes flattened and the longitudinal end of the core 22 becomes bent outwardly by the repulsive fore of the core 22. As the upper end of the core 22 is mounted on the frame 10, only the lower end of the core 22 will be bent outwardly.

To form the core 22, preferably, the core 22 is to be bent in the transverse direction by use of rolling, and it is to be bent in the longitudinal direction, then it passes the heat treatment processing, which makes the longitudinal bending more effectively. The core 22 is surrounded by the skin 24. If the core 22 of metal material is exposed, the appearance may not be desirable, and the user's hands may be hurt by the core 22, and the core 22 is covered by the skin 24 to prevent the above problems. The skin 24 is made of soft and elastic material in order not to reduce the elasticity of the core 22. Preferably the skin 24 is made of silicon rubber. If the core 22 is surrounded by the skin 24, the lower end of the elastic supporting member 20 may not slip or slide on the floor, so the target goods can be stably supported.

The elastic supporting member 20 comprising a core 22 and a skin 24 is placed on the opening 12 of the frame 10, and it is mounted on the upper part of the frame 10 by mounting the engaging portion 26 of the upper end of the core 22 on the frame 10. The numeral 28 is a mounting cap to fasten the elastic supporting member 20 on the frame 10.

As shown in the drawings, engaging holes 27 and engaging recesses 29 are formed on the engaging portion 26 of the core 22 and the mounting cap 28 respectively, and engaging projections 11 are formed on the rear surface of the frame 10 to be inserted into these engaging holes 27 and engaging recesses 29. Accordingly, if the engaging holes 27 of the core 22 and the engaging recesses 29 of the mounting cap 28 are inserted to the engaging projections 11, the core 22 is mounted on the frame 10.

As mentioned above, as the frame 10 has an opening 12, and the elastic supporting member 20 is placed on the opening 12, the elastic supporting member 20 will not project from the frame 10, so the stand may have slim and compact shape. And it is advantageous that the material is reduced and the weight is reduced owing to the opening 12.

Meanwhile, a sticking sheet 30 is attached on the rear surface of the frame 10. The sticking sheet 30 is used to attach the target object on the frame 10. An inserting groove 14 is formed on the rear surface of the frame 10, and the sticking sheet 30 is inserted in the inserting groove 14 so that the top surface of the sticking sheet 30 should project a little from the rear surface of the frame 10. This sticking sheet 30 provides a sticking surface which can be used repeatedly. Various adhesive are known to form a sticking surface to be used repeatedly, and the sticking sheet 30 is made by those adhesives. If the sticking surface of the sticking sheet 30 gets dirty and the sticking force is lowered, the sticking surface can be washed by water, then the sticking force is restored, and it can be used semi-permanently.

Preferably, the surface of the frame 10 can be treated with corona or primer so that the sticking force between the sticking sheet 30 and frame 10 is increased. This is necessary to prevent the sticking sheet 30 from peeling off from the frame 10 when the target object is removed from the sticking sheet 30 of the stand. Preferably a protective film may be attached on the surface of the sticking sheet 30 in order to prevent the surface of the sticking sheet 30 from getting dirty.

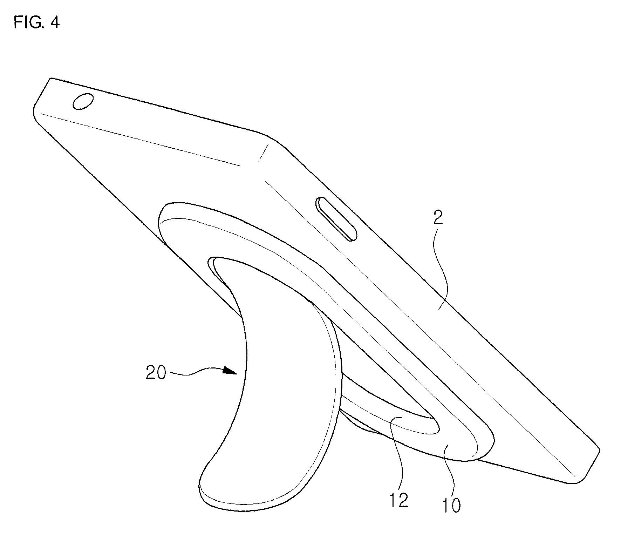

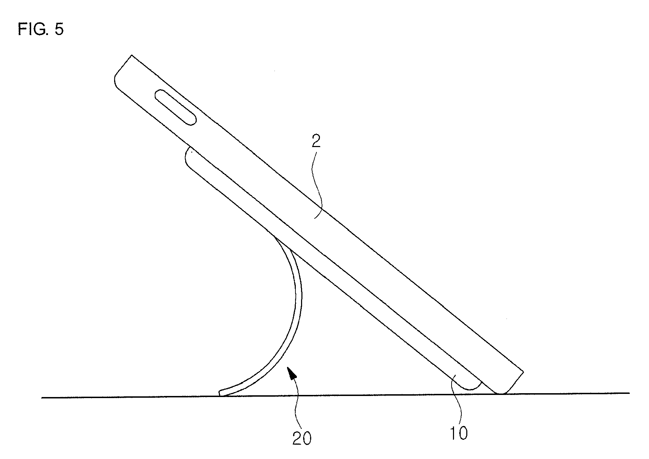

The invention is used as mentioned below. FIG. 4 and FIG. 5 show the smart phone supported on the stand. The sticking sheet 30 is bonded on the rear surface of the smart phone, then the convex central part of the elastic supporting member 20 is pressed. If the convex central part of the elastic supporting member 20 is pressed, the pressed portion becomes supported by the rear surface of the smart phone, and the convex transverse bending becomes flattened, and the repulsive force at this time make the lower end of the elastic supporting member 20 be bent outwardly and the lower end of the elastic supporting member 20 can be supported on the floor, so the smart phone can be supported on the floor in an inclined state by the elastic supporting member 20.

Even though the invention is described to be used to support the smart phone, the invention can support various goods and devices. For example, it can be used to support a hand mirror, a picture or a picture frame, or a note or a pamphlet on the table.

## Claims

1. A sticking type stand comprising;
a frame (10);
an elastic supporting member (20) having an elongated shape, and the longitudinal upper end of it being mounted on the frame (10), the transverse section being curved with the central part being convex outwardly so that, if an external force is exerted on the convex front surface while the concave rear surface is supported, the longitudinal lower end of it can be elastically bent outwardly; and
a sticking sheet (30) provided on the rear surface of the frame (10),
wherein if the target object (2) is attached on the sticking sheet (30), and the convex central part of the elastic supporting member (20) is pressed, then the longitudinal lower end of the elastic supporting member (20) becomes elastically bent outwardly and comes to be supported by the floor so that the target object (2) can be supported on the floor in an inclined state.

2. The sticking type stand of claim 1, wherein the elastic supporting member (20) includes a metal plate core (22) and an elastic skin (24) surrounding the metal plate core (22).

3. The sticking type stand of claim 1 or 2, wherein the frame (10) has an opening (12) with a shape corresponding to that of the elastic supporting member (20), and the elastic supporting member (20) is seated on the opening (12).
